# EUROPEAN PATENT APPLICATION

(11) **EP 3 291 647 A1**
(43) Date of publication of application: **07.03.2018**
(21) Application number: 17157348.8
(22) Date of filing: 22.02.2017
(51) Int. Cl.: H05B 33/08, H02J 9/06

(54) **LIGHT-EMITTING DIODE LIGHT USING RELAY CAPABLE OF DIMMING**

(30) Priority: 31.08.2016 KR 20160111520
(71) Applicant: Kang, Hae Il, Nan-gu, Busan (KR)
(72) Inventor: Kang, Hae Il, Nam-gu, Busan (KR); Lee, Sang Hwan, Gyeongsan-si, Gyeongsangbuk-do (KR); Lee, Jun Taek, Seoul (KR)
(74) Representative: Gulde & Partner

(57) **Abstract**

Disclosed herein is a light-emitting diode (LED) light using a relay capable of dimming. The LED light includes: a first relay unit configured to be supplied with first power from the outside, and to comprise a first relay and a second relay; first and second resistors configured to be supplied with second power or a control signal from the outside, and to drive the first or second relay; a second relay unit configured to cut off the first power when the second power is supplied in a state in which the first power has been supplied to the first relay unit, and to be supplied with the first power when the control signal is received in the state in which the first power has been supplied to the first relay unit; a first SMPS configured to convert AC current; and a second SMPS configured to convert AC current.

## Description

### BACKGROUND

### 1. Technical Field

The present invention relates generally to a light-emitting diode (LED) light using a relay capable of dimming, and more particularly to a scheme for supplying electric current to LED elements, divided into at least two groups, using a relay.

### 2. Description of the Related Art

Fluorescent lamps are widely used as lighting devices. Such fluorescent lamps have disadvantages in that people feel eye strain when using them for long times and high power loss occurs because surrounding temperatures rise due to heat generated during the operation of the fluorescent lamps. LED lights capable of replacing such fluorescent lamps have been recently developed and widely used.

LED lights have desirable efficiency at which power is converted into light, have desirable lighting efficiency for power resulting in desirable economic efficiency, and can obtain a required amount of light even at low voltage. Accordingly, it is expected that the use of LED lights will increase in the future.

For current LED lights, a scheme for dividing LED elements forming such an LED light into a plurality of groups and driving LED elements for each of the groups is being discussed.

In addition, when a dimming technology is applied to such an LED light, the intensity of electric current that is provided to LED elements is controlled according to conventional technology. However, when the intensity of electric current that is provided to LED elements is used as described above, people feel eye strain because a flicker phenomenon in which light flickers due to minute vibration occurs based on the characteristic of noise and, thus, dizziness or a headache is caused.

According to a conventional LED dimming method, power output from an LED converter is supplied in response to a signal having a communication value. The lifespan of a product is reduced because a power factor is decreased by imposing stress on the LED converter.

Accordingly, there is now proposed a dimming technology using a method for dividing LED elements forming an LED light into a plurality of groups and supplying electric current to LED elements for each of the groups.

Furthermore, a conventional LED lighting system is disadvantageous in that communication control varies depending on the capacities, number or locations of LED lights, the costs of a product and equipment increase depending on communication equipment when the LED lights are controlled in an integrated manner, installation is complicated, and compatibility is poor.

### [Preceding technology documents]

### [Patent documents]

(Patent document 0001) Korean Patent Application Publication No. 2014-0123812
(Patent document 0002) Korean Patent Application Publication No. 2014-0100572

### SUMMARY

An object of the present invention is to provide a scheme for supplying electric current to LED elements, divided into at least two groups, by using a relay.

Another object of the present invention is to provide a scheme for improving the power factor of an LED light and mitigating the flicker phenomenon thereof.

Still another object of the present invention is to provide a scheme for controlling LED elements for each group by using a relay.

Still another object of the present invention is to provide a scheme for preventing power, higher than a set power level, from being consumed.

Still another object of the present invention is to provide a scheme for turning on LED element by using power supplied by a power (energy) storage device when the supply of power from the outside is cut off.

Still another object of the present invention is to provide a scheme for turning on only a specific LED element in case of emergency, thereby providing notification of an emergency state.

In accordance with an aspect of the present invention, there is provided an light-emitting diode (LED) light using a relay capable of dimming, the LED light including: a first relay unit configured to be supplied with first power from the outside, and to comprise a first relay and a second relay; first and second resistors configured to be supplied with second power or a control signal from the outside, and to drive the first or second relay; a second relay unit configured to cut off the first power supplied to the first relay unit when the second power is supplied in a state in which the first power has been supplied to the first relay unit, and to be supplied with the first power when the control signal is received in the state in which the first power has been supplied to the first relay unit; a first SMPS connected to the first relay unit, and configured to convert electric current having alternating current (AC) voltage, received from the first relay unit, into electric current having direct current (DC) voltage; and a second SMPS connected to the second relay unit, and configured to convert electric current having AC voltage, received from the second relay unit, into electric current having DC voltage.

### BRIEF DESCRIPTION OF THE DRAWINGS

The above and other objects, features and advantages of the present invention will be more clearly understood from the following detailed description taken in conjunction with the accompanying drawings, in which:
FIG. 1 shows an LED light according to an embodiment of the present invention;
FIG. 2 shows an LED lighting system according to an embodiment of the present invention;
FIG. 3 is a diagram showing the configuration of a relay unit according to an embodiment of the present invention;
FIG. 4 is a diagram showing the configuration of an SMPS according to an embodiment of the present invention;
FIG. 5 shows an LED light according to another embodiment of the present invention;
FIG. 6 shows an LED lighting system according to another embodiment of the present invention;
FIG. 7 is a diagram showing the configuration of a relay unit according to another embodiment of the present invention;
FIG. 8 shows a PCB board forming an LED light according to an embodiment of the present invention;
FIG. 9 shows LED elements included in a first group and the pattern of electric cables for supplying electric current to the LED elements according to an embodiment of the present invention; and
FIG. 10 shows LED elements included in a second group and the pattern of electric cables for supplying electric current to the LED elements according to an embodiment of the present invention.

### DETAILED DESCRIPTION

The above and additional aspects of the present invention will be apparent from preferred embodiments that will be described with reference to the accompanying drawings. The present invention will be described in detail in conjunction with the embodiments so that those skilled in the art can easy understand and reproduce the present invention.

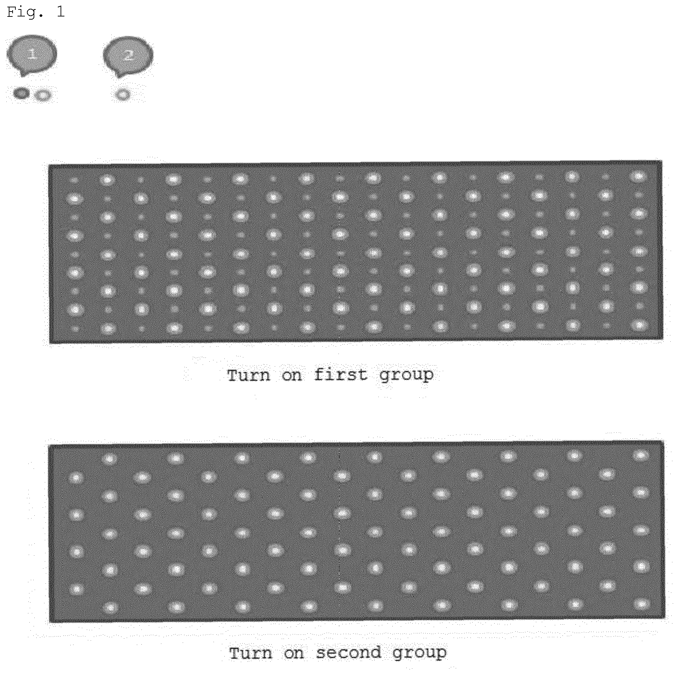

FIG. 1 shows an LED light according to an embodiment of the present invention. The structure of the LED light according to the present embodiment will be described in detail below with reference to FIG. 1.

Referring to FIG. 1, the LED light includes two groups. In addition, the LED light has a rectangular form, and includes a plurality of rows. LED elements are disposed in the rows.

The LED light includes LED elements disposed in odd and even rows. A first LED element group includes all the LED elements disposed in the odd rows and the even rows. A second LED element group includes LED elements that belong to the LED elements disposed in the odd rows and that are disposed at even-numbered locations and LED elements that belong to the LED elements disposed in the even rows and that are disposed at odd-numbered locations.

In addition, the first LED element group includes LED elements included in the second LED element group.

Accordingly, the LED light requires an SMPT for turning on the LED elements included in the first LED element group and an SMPT for turning on the LED elements included in the second LED element group.

More specifically, the LED elements included in each group of the LED light according to the present embodiment are uniformly formed throughout the overall LED light. That is, the LED elements included in the first group are uniformly formed throughout the LED light, and the LED elements included in the second group are uniformly formed throughout the LED light. As described above, in order to uniformly form LED modules, included in each group, throughout the LED light, some of wires for supplying electric current to the LED elements is formed in a zigzag form. The LED light has uniform illumination throughout an overall area because the LED elements are uniformly formed throughout the LED light as described above.

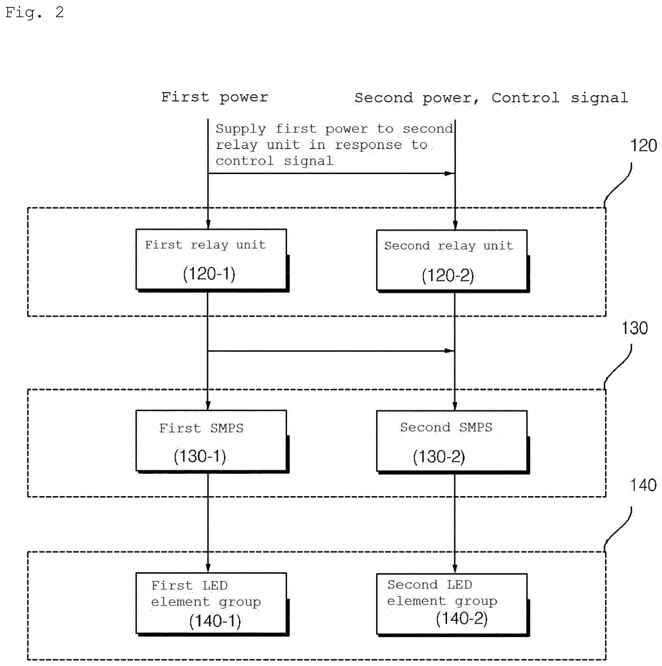

FIG. 2 shows an LED lighting system according to an embodiment of the present invention system. The LED lighting system according to the present embodiment will be described in detail below with reference to FIG. 2.

Referring to FIG. 2, the LED lighting system includes a relay unit 120, an SMPS unit 130, and an LED element unit 140. In addition to the above-described components, another component may be included in the LED lighting system proposed by the present embodiment.

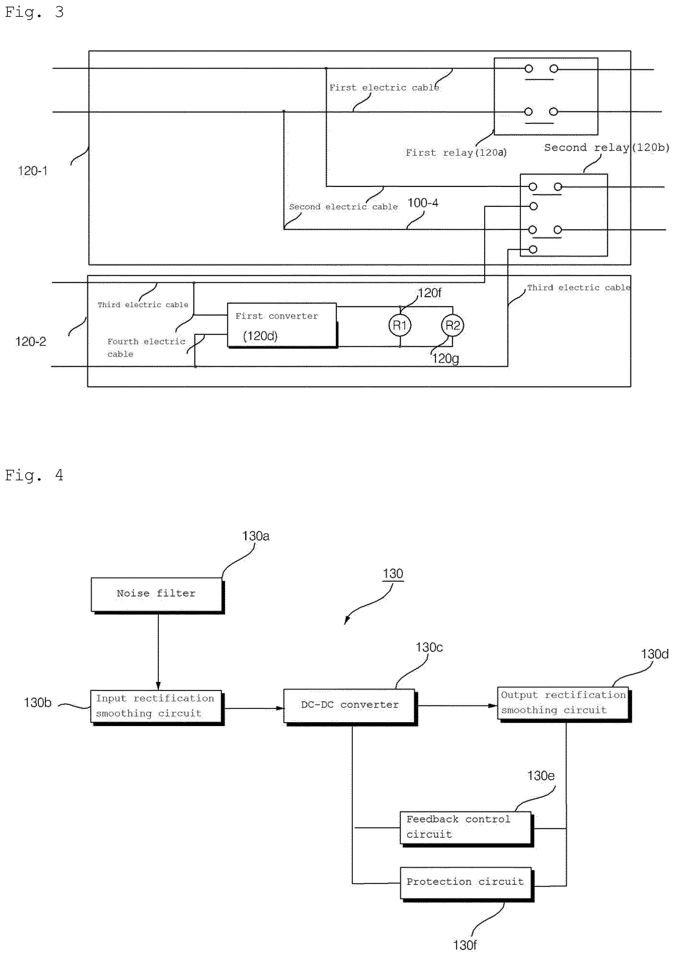

The relay unit 120 transfers power from the outside to the SMPS unit 130. A detailed operation of the relay unit 120 is described in detail with reference to FIG. 3. The first relay unit 120-1 of the relay unit 120 is supplied with first power from the outside, and the second relay unit 120-2 thereof is supplied with second power from the outside. The second relay unit 120-2 is driven in response to a control signal from the outside when it is not supplied with the second power.

The SMPS unit 130 converts alternative current, supplied from the outside, into direct current, converts the direct current into voltage suitable for the condition of the LED element unit 140, and supplies the voltage to the LED element unit 140.

The SMPS unit 130 includes a battery for driving the SMPS unit 130. More specifically, the SMPS unit 130 according to the present embodiment includes a first SMPS unit 130-1 and a second SMPS unit 130-2. The first SMPS unit 130-1 and the second SMPS unit 130-2 are connected to LED element units 140-1 and 140-2 corresponding to respective groups. The first SMPS unit 130-1 is connected to the LED element unit 140-1 corresponding to a first group. The second SMPS unit 130-2 is connected to the LED element unit 140-2 corresponding to a second group. Accordingly, when power is supplied to the first SMPS unit 130-1, the LED element unit 140-1 of the first group is turned on. When power is supplied to the second SMPS unit 130-2, the LED element unit 140-2 of the second group is turned on.

FIG. 3 is a diagram showing the configuration of a relay unit 120 according to an embodiment of the present invention. The configuration of the relay unit 120 according to the present embodiment will be described in detail below with reference to FIG. 3.

Referring to FIG. 3, the relay unit 120 includes a first relay unit 120-1 and a second relay unit 120-2. When the number of SMPSs increases, the number of relays included in the relay unit 120 also increases.

The first relay unit 120-1 is connected to first power, and the second relay unit is connected to second power or a control signal.

The first relay unit 120-1 includes a first relay 120a and a second relay 120b. The first relay unit 120-1 is supplied with the first power (or current) from the outside. An electric cable with which the current is supplied is branched into two branch electric cables in a parallel form. A first electric cable, i.e., one of the two branch electric cables, is connected to the first SMPS unit 130-1. A second electric cable, i.e., the other electric cable, is connected to the second SMPS unit 130-2.

The first relay 120a is formed on the first electric cable, and the second relay 120b is formed on the second electric cable.

The second relay unit 120-2 is supplied with the second power (or current) from the outside, and includes a first resistor 120c and a second resistor 120d. Furthermore, the second relay unit 120-2 receives a control signal 120e from the outside. The first resistor 120c and the second resistor 120d are connected in parallel, and the control signal 120e is connected to the first resistor 120c.

The electric cable with which the second power (or current) is supplied is branched in parallel. A third branch electric cable is connected to the second relay 120b. Furthermore, a fourth branch electric cable is connected to the first resistor 120c and the second resistor 120d.

When the first power is supplied from the outside to the first relay unit 120-1, the first relay 120a and the second relay 120b are connected. Accordingly, electric current flows through the first SMPS unit 130-1 and the second SMPS unit 130-2. When the current is supplied to the first SMPS and the second SMPS, the LED elements of the first group connected to the first SMPS are turned on, and the LED elements of the second group connected to the second SMPS are turned on.

When the second power is supplied from the outside to the second relay unit 120-2, the first relay is short-circuited by electric current flowing into the first resistor 120c, and thus the supply of electric current to the first SMPS unit 130-1 is cut off. When the supply of electric current to the first SMPS is cut off, the LED elements of the first group are turned off.

Furthermore, when the second power is supplied from the outside to the second relay unit 120-2, the second relay 120b connects the third electric cable to the second SMPS unit 130-2 in response the current flowing through the second resistor 120d. That is, the second SMPS unit 130-2 is not supplied with electric current from the first power, but is supplied with electric current from the second power. Accordingly, the LED elements of the second group connected to the second SMPS are turned on.

As described above, in the embodiment of the present invention, when electric current is supplied from the second power, the supply of electric current from the first power is automatically cut off. Furthermore, when the supply of electric current from the second power is cut off, electric current is automatically supplied from the first power.

As described above, the first SMPS unit 130-1 is connected to a first LED element group, and the second SMPS unit 130-2 is connected to a second LED element group. Furthermore, an LED light capable of dimming can be simply constructed by making the number of LED elements forming the first LED element group different from the number of LED elements forming the second LED element group. As shown in FIG. 2, LED elements forming the first LED element group may be included in the LED elements forming the second LED element group.

Furthermore, in an embodiment of the present invention, when the control signal is input to the second relay unit 120-2 in the state in which the second power has not been supplied, the first resistor 120c is driven in response to the control signal. When the first resistor is driven, the first relay 120a is short-circuited and thus the supply of electric current to the first SMPS unit 130-1 is cut off. When the supply of electric current to the first SMPS is cut off, the LED elements of the first group are turned off.

However, the second resistor 120d is not driven in response to the control signal. Accordingly, the second relay 120b connects power, supplied to the second electric cable, to the second SMPS unit 130-2. That is, the second SMPS is supplied with electric current from the first power, and thus the LED elements of the second group connected to the second SMPS are turned on.

As described above, the LED elements of the second group are turned on using the first power in response to the control signal.

Although not explicitly shown in FIG. 3, a fuse may be connected to the front ends of the first relay and the second relay. The fuse blocks the supply of overload to the first relay or the second relay.

A scheme for using the LED light using a relay according to the present invention will be described below.

The LED light using a relay according to the present invention may be configured to turn on LED elements via the first power. When LED elements are turned on via the first power as described above, the LED elements of the first group and the LED elements of the second group are turned on. If power consumed by another electrical product exceeds a set power level in this state, some of the LED elements may be turned off via the supply of the second power. When only the LED elements of the first LED element group are turned on as described above, the power that is consumed by the LED light can be reduced and thus power consumption can be reduced.

As described above, the power that is consumed by the LED light can be controlled via the control of power that is supplied to the relay unit 120. Accordingly, power consumption reaches the set power level or a lower power level.

FIG. 4 is a diagram showing the configuration of an SMPS according to an embodiment of the present invention. The configuration of the SMPS according to the present embodiment will be described in detail below with reference to FIG. 4.

Referring to FIG. 4, the SMPS includes a noise filter 130a, an input rectification smoothing circuit 130b, a DC-DC converter 130c, an output rectification smoothing circuit 130d, a feedback control circuit 130e, and a protection circuit 130f. In addition to the above-described components, another component may be included in the SMPS proposed by the present embodiment.

The noise filter 130a removes a noise part from received current, and sends the current, from which noise has been removed, to the input rectification smoothing circuit 130b.

The input rectification smoothing circuit 130b converts the current (having AC voltage), from which noise has been removed, into DC voltage.

The DC-DC converter 130c converts the DC voltage, obtained by the input rectification smoothing circuit 130b, into set voltage. In general, the DC-DC converter 130c includes a main switch, a feedback diode, and an LC filter, i.e., a secondary bandpass filter.

The output rectification smoothing circuit 130d smoothes the DC voltage, obtained by the DC-DC converter, once again, and outputs the smoothed DC voltage.

The feedback control circuit 130e stabilizes the voltage output by the output rectification smoothing circuit. In general, the feedback control circuit 130e includes an error amplifier for amplifying an error of output voltage, a comparator for generating a driving pulse by comparing the amplified error with a chopping wave, and a driving circuit for driving the main switch of the DC-DC converter.

The protection circuit 130 is connected in parallel to the feedback control circuit 130e, and functions to protect a circuit forming the SMPS.

The SMPS may be constructed using a method different from the above-described construction method.

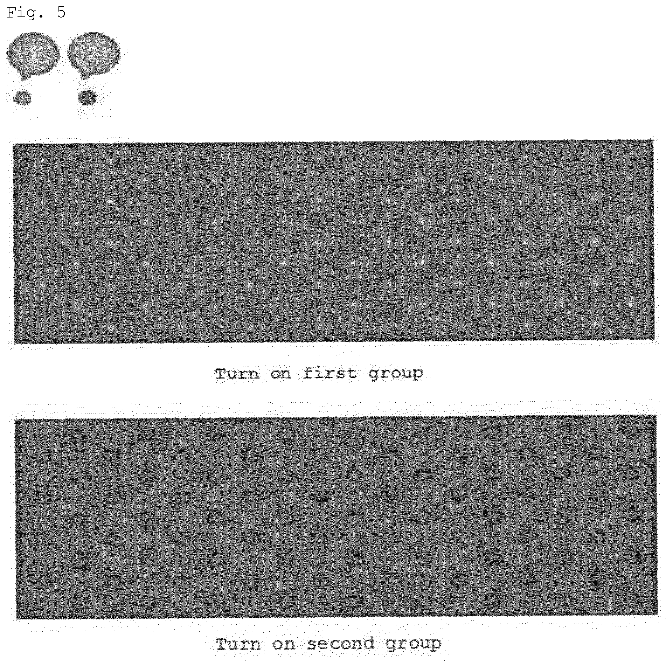

FIG. 5 shows an LED light according to another embodiment of the present invention. The structure of the LED light according to the present embodiment will be described in detail below with reference to FIG. 5.

Referring to FIG. 5, the LED light includes two groups. In addition, the LED light has a rectangular form, and includes a plurality of rows. LED elements are disposed in the rows.

The LED light includes LED elements disposed in odd and even rows. A first LED element group includes LED elements that belong to the LED elements disposed in the odd rows and that are placed at odd-numbered locations and LED elements that belong to the LED elements disposed in the even rows and that are placed at even-numbered locations. A second LED element group includes LED elements that belong to the LED elements disposed in the odd rows and that are placed at even-numbered locations and LED elements that belong to the LED elements disposed in the even rows and that are placed at odd-numbered locations.

In addition, in FIG. 5, the LED elements included in the first LED element group do not overlap the LED elements included in the second LED element group unlike in FIG. 1.

Accordingly, the LED elements of the first LED element group or the LED elements of the second LED element group may be turned on using a single SMPS.

More specifically, the LED elements included in each group of the LED light according to the present embodiment are uniformly formed throughout the overall LED light. That is, the LED elements included in the first group are uniformly formed throughout the LED light, and the LED elements included in the second group are uniformly formed throughout the LED light. As described above, in order to uniformly form LED modules, included in each group, through the LED light, some of wires for supplying electric current to the LED elements is formed in a zigzag form. The LED light has uniform illumination throughout the overall area because the LED elements are uniformly formed throughout the LED light as described above.

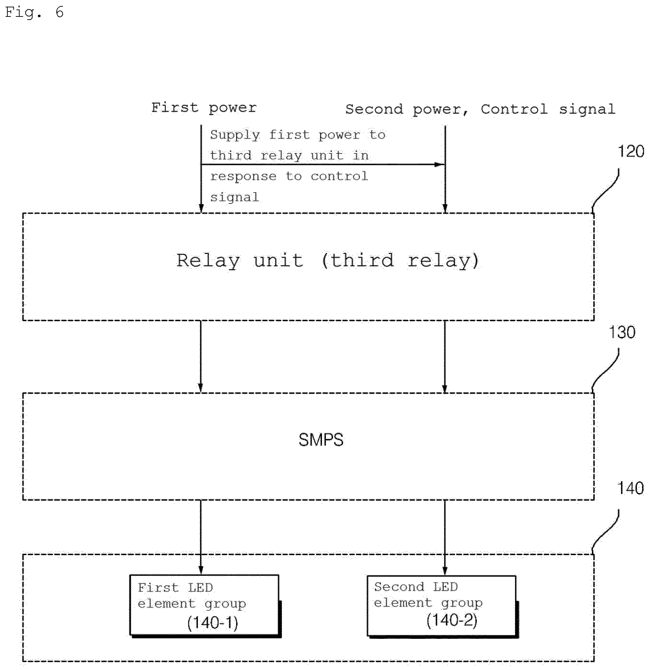

FIG. 6 shows an LED lighting system according to another embodiment of the present invention. The LED lighting system according to the present embodiment will be described in detail below with reference to FIG. 6.

Referring to FIG. 6, the LED lighting system includes a relay unit 120, an SMPS unit 130, and an LED element unit 140. In addition to the above-described components, another component may be included in the LED lighting system proposed by the present embodiment.

The relay unit 120 is supplied with first or second power from the outside. Furthermore, when the second power is not supplied to the relay unit 120 but a control signal is received, the relay unit 120 supplies the first power to the SMPS unit 130.

The SMPS unit 130 converts AC, supplied from the outside, into DC, converts the DC into voltage suitable for the condition of the LED element unit 140, and supplies the voltage to the LED element unit 140. As described above, unlike FIG. 2, FIG. 6 includes a single SMPS. The SMPS is connected to an LED element unit 140-1 included in a first group, or is connected to an LED element unit 140-2 included in the second groups. Accordingly, the LED element unit 140-1 of the first groups or the LED element unit 140-2 of the second group is turned on using the SMPS unit 130. The LED elements of the first group are turned on by power supplied from the first power. The LED elements of the second group are turned on by power supplied from the second power or by power supplied from the first power in response to the control signal. That is, the control signal turns on the LED elements of the second group using the first power.

The SMPS unit 130 includes a battery for driving the SMPS unit 130.

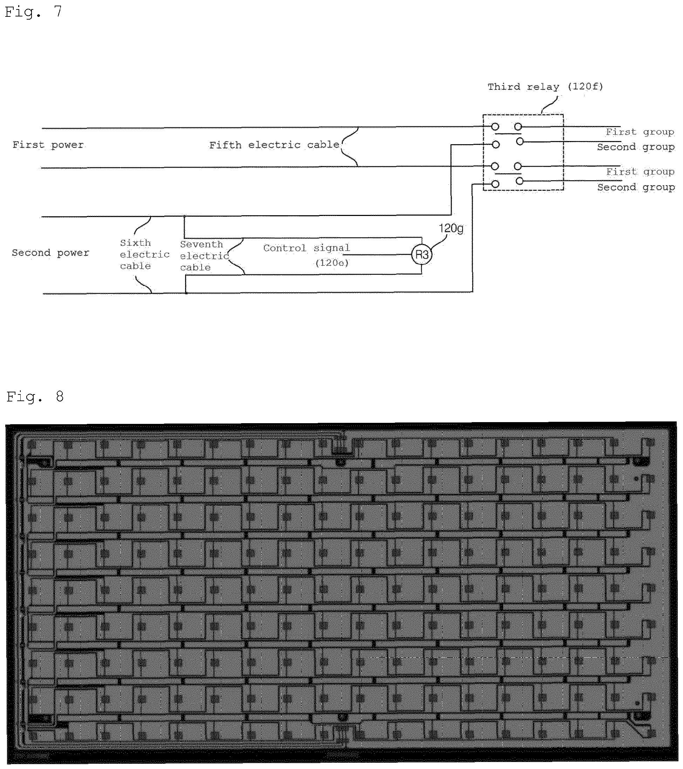

FIG. 7 is a diagram showing the configuration of a relay unit according to another embodiment of the present invention. The configuration of the relay unit according to the present embodiment will be described in detail below with reference to FIG. 7.

Referring to FIG. 7, a third relay 120f is supplied with power from first power or from second power. When power is supplied from the first power, the third relay 120f supplies electric current, supplied through a fifth electric cable, to the LED elements of a first group. The fifth electric cable connects the first power and the third relay 120f.

The relay unit includes a sixth electric cable connecting the second power and the third relay 120, and a seventh electric cable connecting the second power and a third resistor 120g. The third resistor 120g is connected to the third relay 120f.

When the second power is supplied, electric current flows through the third resistor 120g. Accordingly, the third relay 120f supplies the LED elements of the second group with the current supplied through the sixth electric cable.

Furthermore, when a control signal 120e is received in the state in which the second power has not been supplied, the third resistor 120g is driven in response to the control signal. When the third resistor is driven, the third relay 120 is driven. Accordingly, the first power supplied through the fifth electric cable is supplied to the LED elements of the second group.

As described above, the LED elements of the second group are turned on by the first power in response to the control signal.

FIG. 8 shows a PCB board forming an LED light according to an embodiment of the present invention. The structure of the PCB board forming the LED light according to the present embodiment will be described in detail below with reference to FIG. 8.

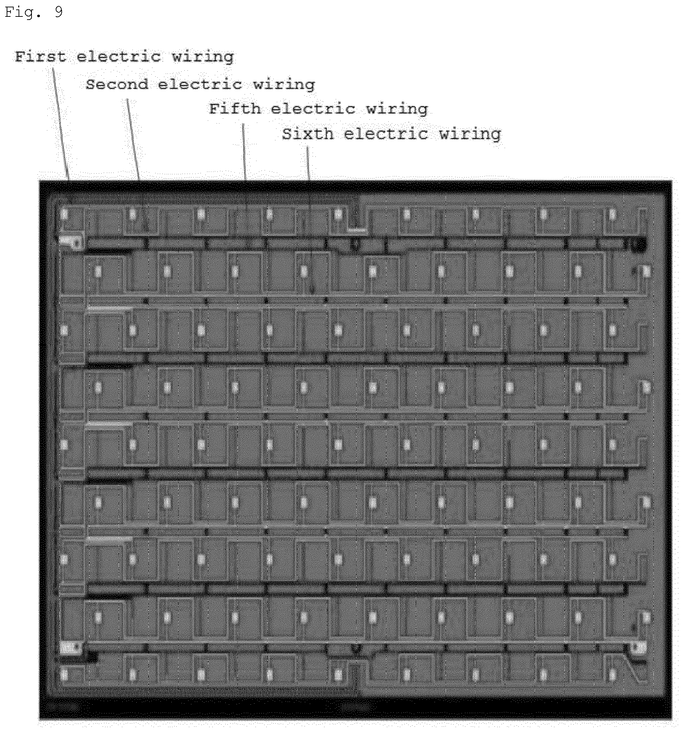

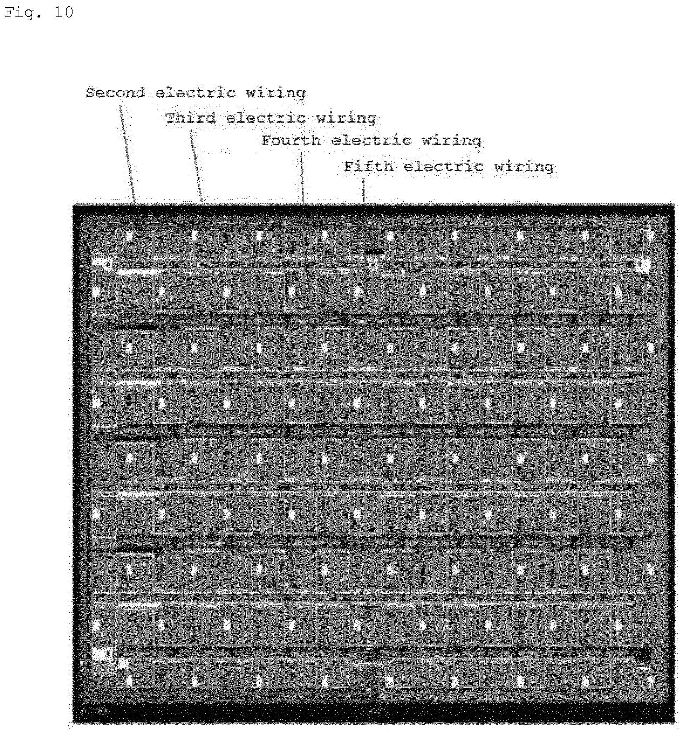

In FIG. 8, portions indicated in a blue portion correspond to LED elements. As shown in FIG. 8, a plurality of LED elements is disposed in rows. Electric wires for supplying electric current to the LED elements are formed in a pattern form. As shown in FIG. 8, some of the electric cables for supplying electric current to the LED elements are formed in a zigzag form. Furthermore, the PCB board is divided into the two groups as described above. LED elements are disposed in each group. The LED elements included in each group and the pattern of electric cables for supplying electric current to the LED elements will be described in detail below with reference to FIGS. 9 and 10.

FIG. 9 shows LED elements included in a first group and the pattern of electric cables for supplying electric current to the LED elements according to an embodiment of the present invention. The LED elements included in the first group and the pattern of the electric cables for supplying electric current to the LED elements according to the present embodiment will be described in detail below with reference to FIG. 9.

Referring to FIG. 9, the LED elements of the first group are disposed in odd and even rows. More specifically, the LED elements are disposed in the odd and even rows at specific intervals. In addition, the LED elements of the first group and the LED elements of the second group are alternately disposed in the odd rows.

The pattern of the electric cables for supplying electric current to the LED elements of the first group is described below. The electric cables for supplying electric current to the first group and the second group are disposed in a parallel form. In addition, LED elements forming a conventional LED light are disposed in a series form. Dimming is performed by controlling the amount of current supplied to the LED elements disposed in a series form. In contrast, LED elements forming an LED light proposed by an embodiment of the present invention are disposed in a parallel form. Dimming is performed by turning on/off electric current supplied to the LED elements disposed in a parallel form. That is, electric current is supplied to the LED elements of the first group or to the LED elements of the second group. Furthermore, electric current may be supplied to LED elements included in at least the two groups.

In order to supply electric current to LED elements included in the first row of the first group, a first wiring and a second wiring are formed. In order to supply electric current to LED elements included in the second row of the first group, a fifth wiring and a sixth wiring are formed. The second wiring is located below the first wiring, and the fifth wiring is located below the second wiring. Furthermore, the sixth wiring is located below the fifth wiring.

As shown in FIG. 9, the first wiring and the sixth wiring are formed in a straight-line form, whereas the second wiring and the fifth wiring are formed in a zigzag form. LED elements are disposed in the region in which the distance between the first wiring and the second wiring is relatively distant because the second wiring and the fifth wiring are formed in a zigzag form. That is, the LED elements are located between the first wiring and the second wiring, and the first wiring and the second wiring are connected. In addition, the second wiring is formed in a zigzag form in order to form the space in which the LED elements are to be disposed between the first wiring and the second wiring.

LED elements are located between the fifth wiring and the sixth wiring. The fifth wiring is formed in a zigzag form in order to form the space in which the LED elements are to be disposed between the fifth wiring and the sixth wiring.

FIG. 10 shows LED elements included in a second group and the pattern of electric cables for supplying electric current to the LED elements according to an embodiment of the present invention. The LED elements included in the second group and the pattern of the electric cables for supplying electric current to the LED elements according to an embodiment of the present invention are described in detail below with reference to FIG. 10.

Referring to FIG. 10, the LED elements of the second group are disposed in even rows and odd rows. More specifically, the LED elements are disposed in the even rows and the odd rows at specific intervals. As described above, the LED elements of the first group and the LED elements of the second group are alternately disposed in the odd rows.

Second wiring and third wiring are formed to supply electric current to the LED elements included in the first row of the second group. Fourth wiring and fifth wiring are formed to supply electric current to the LED elements included in the second row of the second group. As described above, the third wiring is disposed relatively on the lower side of the second wiring, and the fourth wiring is disposed relatively on the lower side of the third wiring. Furthermore, the fifth wiring is disposed relatively on the lower side of the fourth wiring. In addition, the second wiring and the fifth wiring are the same as the second wiring and the fifth wiring for supplying electric current to the LED elements of the first group.

As shown in FIG. 10, the third wiring and the fourth wiring are formed in a straight-line form, whereas the second wiring and the fifth wiring are formed in a zigzag form as described above. The LED elements are disposed in the region in which the distance between the second wiring and the third wiring is relatively distant because the second wiring and the fifth wiring are formed in a zigzag form. That is, the LED elements are located between the second wiring and the third wiring, and the second wiring and the third wiring are connected. In addition, the second wiring is formed in a zigzag form in order to form the space in which the LED elements are to be disposed between the second wiring and the third wiring.

In other words, the second wiring is located between the first wiring and the third wiring, and the first wiring and the third wiring are disposed in a straight-line form. In contrast, the second wiring is disposed in a zigzag form. The second wiring is connected to the first wiring or the third wiring through the LED elements.

Furthermore, the LED elements are disposed between the fourth wiring and the fifth wiring. The fifth wiring is formed in a zigzag form in order to form the space in which the LED elements are to be disposed between the fourth wiring and the fifth wiring.

In other words, the fifth wiring is located between the fourth wiring and the sixth wiring, and the fourth wiring and the sixth wiring are disposed in a straight-line form. In contrast, the fifth wiring is disposed in a zigzag form. The fifth wiring is connected to the fourth wiring or the sixth wiring through the LED elements.

As described above, the LED light using a relay capable of dimming according to the present invention supplies electric current to LED elements, divided into at least two groups, by using the relay. Accordingly, the LED light according to the present invention is advantageous in that a power factor is improved and a flicker phenomenon is mitigated.

Furthermore, the LED light according to the present invention can prevent power from being unnecessarily consumed because a user can turn on LED elements, divided into groups, for each group by using the relay.

Furthermore, according to the present invention, when the supply of power from the outside is cut off, LED elements can be turned on by using power supplied from a power (energy) storage device. Accordingly, an advantage arises in that notification of an emergency state can be provided because only a specific LED element is turned on in case of emergency.

Although the present invention has been described with reference to the embodiments shown in the accompanying drawings, these embodiments are merely examples. Accordingly, it will be appreciated by those having ordinary knowledge in the art that various modifications and other equivalent embodiments can be made.

## Claims

1. An light-emitting diode (LED) light using a relay capable of dimming, the LED light comprising:
a first relay unit configured to be supplied with first power from an outside, and to comprise a first relay and a second relay;
first and second resistors configured to be supplied with second power or a control signal from an outside, and to drive the first or second relay;
a second relay unit configured to cut off the first power supplied to the first relay unit when the second power is supplied in a state in which the first power has been supplied to the first relay unit, and to be supplied with the first power when the control signal is received in the state in which the first power has been supplied to the first relay unit;
a first SMPS connected to the first relay unit, and configured to convert electric current having alternating current (AC) voltage, received from the first relay unit, into electric current having direct current (DC) voltage; and
a second SMPS connected to the second relay unit, and configured to convert electric current having AC voltage, received from the second relay unit, into electric current having DC voltage.

2. The LED light of claim 1, further comprising:
LED elements included in a first group; and
LED elements included in a second group;
wherein the first SMPS is connected to the LED elements included in the first group and the second SMPS is connected to the LED elements included in the second group.

3. The LED light of claim 2, wherein:
the first relay unit comprises a first electric cable configured to comprise the first relay having a first side connected to the first power and a second side connected to the first SMPS, and a second electric cable configured to comprise the second relay having a first side connected to the first power and a second side connected to the second SMPS; and
the first electric cable and the second electric cable are connected in parallel.

4. The LED light of claim 3, wherein:
the second relay unit comprises a third electric cable configured to have a first side connected to the second power and a second side connected to the second relay, and a fourth electric cable configured to have a first side connected to the second power and a second side connected to the first resistor and the second resistor;
when electric current is supplied to the second relay unit via the second power, the first relay is driven by the first resistor and electric current supplied to the first SMPS is cut off; and
when the second relay is driven by the second resistor, electric current supplied through the second electric cable is cut off and electric current is supplied to the second SMPS through the third electric cable.

5. An LED light using a relay capable of dimming, the LED light comprising:
a relay unit configured to be supplied with first power or second power from an outside or to be supplied with a control signal, and to cut off the first power supplied to the relay unit when the second power is supplied in a state in which the first power has been supplied and maintain the first power supplied to the relay unit when the control signal is received in a state in which the first power has been supplied;
an SMPS connected to the relay unit, and configured to convert electric current of AC voltage, received from the relay unit, into electric current of DC voltage; and
LED elements included in a first group and LED elements included in a second group;
wherein the LED elements included in the first group are turned on by power supplied from the first power; and
wherein the LED elements included in the second group are turned on by power supplied from the second power or power supplied from the first power in response to the control signal.

6. The LED light of claim 5, wherein the relay unit comprises:
a fifth electric cable connected to the first power;
a sixth electric cable connected to the second power;
a third resistor connected to the second power; and
a third relay located at ends of the fifth electric cable and the sixth electric cable.

7. The LED light of any one of claims 2 and 5, further comprising a PCB board comprising LED elements of the first group disposed at odd-numbered locations in odd rows or at even-numbered locations at even rows and LED elements of the second group disposed at even-numbered locations in the odd rows or at odd-numbered locations at the even rows;
wherein the PCB board comprises a first wiring, a second wiring, a fifth wiring and a sixth wiring for supplying electric current to the LED elements of the first group, or comprises a second wiring, a third wiring, a fourth wiring and a fifth wiring for supplying electric current to the LED elements of the second group.
